# EUROPEAN PATENT APPLICATION

(11) **EP 4 571 830 A1**
(43) Date of publication of application: **18.06.2025**
(21) Application number: 24212918.7
(22) Date of filing: 14.11.2024
(51) Int. Cl.: H01L 23/48

(54) **ELECTRONIC DEVICE HAVING A BRASABLE METAL PAD COVER AND ASSOCIATED METHOD**

(30) Priority: 01.12.2023 US 202318526447
(71) Applicant: STMicroelectronics International N.V., 1228 Plan-les-Ouates, Geneva (CH)
(72) Inventor: MOLGG, Michele, 20684 AGRATE BRIANZA (MB) (IT); TEOH, Mooi Kun, 768135 SINGAPORE (SG); CASTORINA, Maurizio Gabriele, 328190 SINGAPORE (SG)
(74) Representative: Studio Torta S.p.A.

(57) **Abstract**

Electronic device comprising a semiconductor substrate (170), an aluminum pad (110) on the semiconductor substrate, and a stack (100). The stack (100) comprises, in sequence, a barrier layer (120) directly deposited on the aluminum pad, a seed layer (130) directly deposited on the barrier layer, the seed layer comprising copper and having a thickness less than 800 nanometers, and a metal layer (140) directly deposited on the seed layer, the metal layer comprising nickel and palladium.

## Description

### TECHNICAL FIELD

The present invention relates generally to integrated circuit fabrications and, more particularly, to brasable metal layers on aluminum pads of integrated circuits.

### BACKGROUND

In the field of power devices (e.g., silicon carbide (SiC) technology), there is need to cover the aluminum pad of such devices with a brasable (or wettable) metal. A brasable metal is a metal able to be uniformly covered by a solder paste. This allows a stable attachment of the clips used in packaging to the aluminum pad.

Currently, the coverage of brazable metal on aluminum metallizations (e.g., 450 nm thick) can be achieved by a PVD (Physical Vapor Deposition) of a Ti/NiV/Ag (titanium/nickel vanadium/silver) layer, with thicknesses of 150/300/500 nm, respectively or an e-less (Electroless) deposition of a Ni/Pd/Au (nickel/palladium/gold) layer.

However, current solutions of brazable metal deposition on aluminum pads may have the disadvantages of creating insufficiently strong contacts and not being fully adaptable to the needs of the electronic device end-user during the soldering steps, for example, due to delamination of the NiV/Ag interface and due to limited NiV thicknesses; in addition, the e-less deposition technique may cause, especially for relatively large pads, inherent corrosion problems of the Ni layers due to the Au immersion reaction.

### SUMMARY

Therefore, the problem arises of developing an electronic device with brazable metal pad coverage and related method that overcomes the disadvantages of the prior art.

According to the invention, an electronic device and a method for manufacturing an electronic device are provided, as defined in the attached claims.

### BRIEF DESCRIPTION OF THE DRAWINGS

Reference will now be made to the accompanying drawings, which are not necessarily drawn to scale, and wherein:
Fig 1 is a cross-sectional view of an example portion of an electronic device, in accordance with an embodiment of the present disclosure; and
Fig. 2 is a cross-sectional view of an example portion of an electronic device, in accordance with an alternative embodiment of the present disclosure.

### DETAILED DESCRIPTION

As used herein, terms such as "front," "rear," "top," etc. are used for explanatory purposes in the examples provided below to describe the relative position of certain components or portions of components. Furthermore, as would be evident to one of ordinary skill in the art in light of the present disclosure, the terms "substantially" and "approximately" indicate that the referenced element or associated description is accurate to within applicable engineering tolerances.

The present disclosure overcomes the above technical challenges and difficulties based on providing nickel-palladium (Ni-Pd) as a brasable metal layer on an aluminum pad of an electronic device, which provides good coverage by the solder paste for attaching a clip to the aluminum pad.

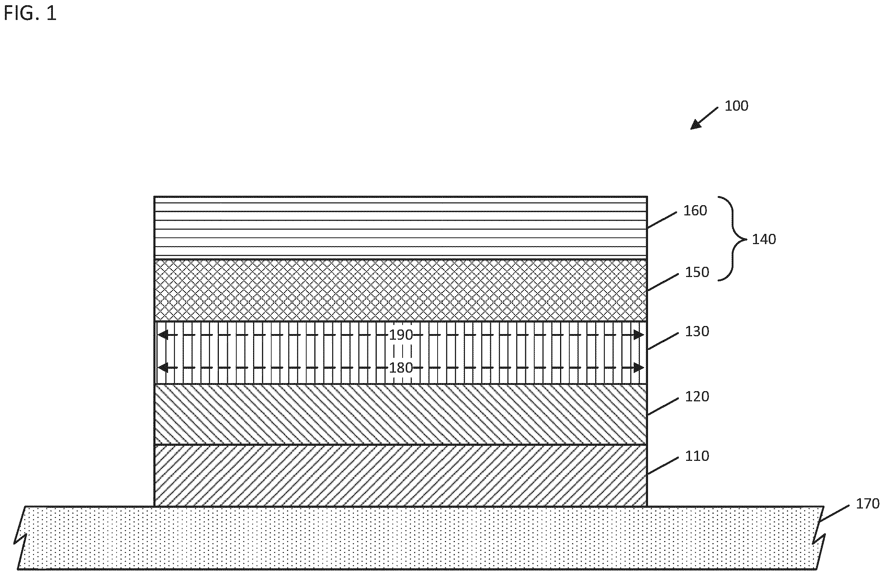

Figure 1 illustrates a cross-sectional view of an electronic device. As seen in figure 1, the electronic device comprises a semiconductor substrate 170 and an aluminum pad 110 placed thereon. For example, the aluminum pad has an area (in plan view) of 1000 x 1000 square micrometers (µm²). Aluminum pads of any area could be used, for example having an area of 420 x 560 µm² or an area of 2040 x 1900 µm².

The electronic device further comprises a stack 100 which comprises a barrier layer 120 directly deposited on the aluminum pad 110, a seed layer 130 directly deposited on the barrier layer 120, and a metal layer 140 directly deposited on the seed layer 130.

Exemplarily the stack 100 continuously and entirely covers the aluminum pad (in other words, the area - in plan view - of the stack is at least equal to the area - in plan view - of the aluminum pad).

In figure 1, the metal layer 140 comprises a nickel sub-layer 150 and a palladium sub-layer of 160.

The seed layer 130 may comprise a layer of copper. The seed layer 130 may comprise a single layer of copper, for example having a thickness less than 800 nanometers (nm), in particular having a thickness of 250-600 nm, and more in particular a thickness of about 300-500 nm.

The barrier layer 120 may comprise titanium, titanium-nitride, titanium-tungsten, tantalum, and/or tantalum-nitride.

For example, the nickel sub-layer 150 of the metal layer 140 is directly deposited on the seed layer 130 and the palladium sub-layer 160 of the metal layer 140 is directly deposited on the nickel sub-layer 150 of the metal layer 140.

The metal layer 140 may have a thickness greater than (or equal to) 500 nm. In particular, the nickel sub-layer 150 is at least 500 nm, and the palladium sub-layer 160 is at least 150 nm.

The metal layer 140 may be deposited via electroless deposition (also termed e-less deposition), that is both the nickel and the palladium sub-layers 150, 160 may be deposited via electroless deposition.

Using electroless deposition enables the thickness of the nickel and palladium sub-layers 150, 160 to be modulated within a large range and with a greater thickness than with other deposition techniques.

The thickness of the nickel and palladium sub-layers 150, 160 is modulated as a function of the technological purpose. For example, as regards the nickel sub-layer 150, the thickness can vary in a range of 500-5000 nm, depending on the technological purpose (e.g., barrier function, mechanical buffer function, and/or chemical reaction function). For example, the nickel sub-layer may have a thickness able to withstand the nickel consumption (so that a certain thickness still remains in the final device) due to the wire bonding process (occurring in a later production phase) when the solder paste is positioned on the palladium.

The palladium sub-layer 160 has the function to protect the nickel sub-layer 150 and to be wettable, therefore in some embodiments a range of 150-500 nm is used.

Using electroless deposition enables the nickel sub-layer 150 to have for example a thickness in the abovesaid range of 500 nm to 5 micrometers.

The use of a nickel-palladium metal layer 140 deposited by electroless deposition enables a greater total stack height as compared to other approaches that have been used, which may be desirable in some applications.

The barrier layer 120 and the seed layer 130 may be deposited via physical vapor deposition. Alternatively, any suitable deposition method may be used for these layers.

The width of the seed layer may be substantially constant from the barrier layer 120 to the metal layer 140. For the purposes of the present disclosure, the expression "substantially constant" means that an actual width value of the seed layer varies, along a direction going from the barrier layer to the metal layer, within a range of +/- 10% (and preferably of +/- 5 %) from a nominal width value. For example, the nominal width value may be 1000 µm and the actual width value may be between 900 µm and 1100 µm. This is illustrated in figure 1 by the substantially equal length dashed lines 180, 190 indicating the width of the seed layer 130, with the dashed line 180 indicating the width at a lower point of the seed layer 130 (i.e., closer to the barrier layer 120) and the dashed line 190 indicating the width at a higher point of the seed layer 130 (i.e., closer to the nickel sub-layer 150).

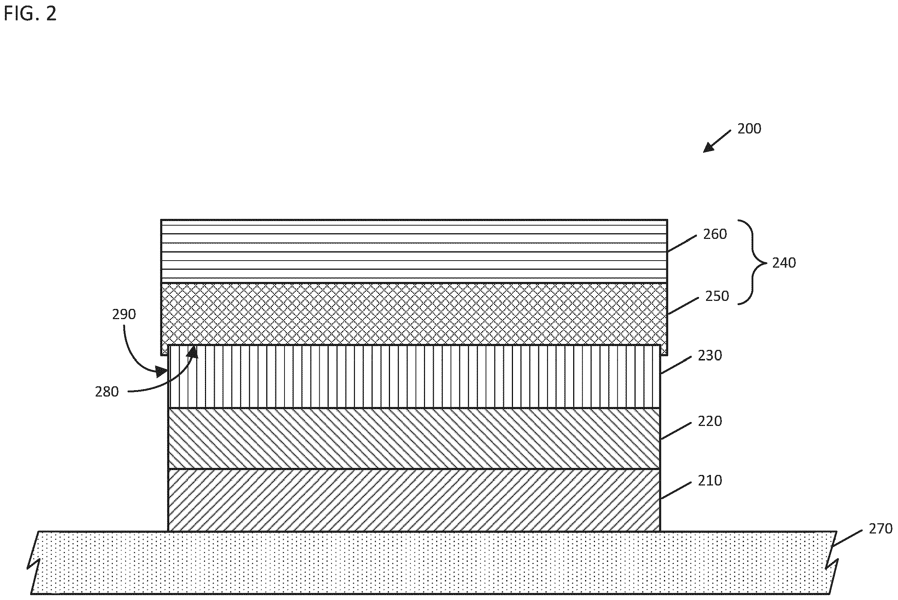

Figure 2 illustrates a cross-sectional view of a stack of an electronic device, in accordance with an embodiment of the present disclosure.

As seen in figure 2, the electronic device comprises a semiconductor substrate 270 and an aluminum pad 210 placed thereon.

The electronic device further comprises a stack 200 which comprises a barrier layer 220 directly deposited on the aluminum pad 210, a seed layer 230 (such as copper) directly deposited on the barrier layer 220, and a metal layer 240 directly deposited on the seed layer 230.

In figure 2, the metal layer 240 comprises a nickel sub-layer 250 and a palladium sub-layer 260.

In figure 2, the nickel sub-layer 250 of the metal layer 240 substantially covers a top surface 280 of the seed layer 230. Here, as illustrated, the electroless deposition of the nickel sub-layer 250 causes a partial deposition of the nickel also on at least a portion of the sidewall 290 of the seed layer 230, thus completely covering the top surface 280 of the seed layer 230.

The stacks 100, 200 of figures 1, 2 may be manufactured by:
providing an aluminum pad 110, 210 on a semiconductor substrate 170, 270 of an electronic device; and
forming the stack on the aluminum pad, by:
   depositing a barrier layer 120, 220 directly on the aluminum pad 110, 210;
   depositing a seed layer 130, 230 directly on the barrier layer 120, 220, the seed layer comprising copper and having a thickness less than 800 nanometers (nm); and depositing a metal layer 140, 240 directly on the seed layer 130, 230, the metal layer comprising nickel and palladium.

The stack as described herein provides a more uniform interface among the different layers and thereby avoids delayering, as compared to other approaches that have been used. Moreover, the presence of the barrier and seed layers between the aluminum pad and the nickel sub-layer allows to avoid the direct deposition of the nickel, for example through the e-less process, on the aluminum. In fact, Applicant has verified that the e-less chemistry for depositing the nickel on aluminum could cause a damaging of the pad that is difficult to predict.

In embodiments of the present disclosure, the interposition of barrier layer 120, 220 and seed layer 130, 230 allows to obtain a more regular surface of the aluminum pad on one side, and, on the other, the deposition of the nickel on a surface (i.e., the seed layer) substantially insensitive to the action of the e-less chemistry, thus achieving an overall better interface.

The disclosed structure may be used with any electronic device having an aluminum pad requiring a wettable/brasable metal, including but not limited to SiC devices as described herein, as well as gallium nitride or silicon devices (e.g., insulated-gate bipolar transistors (IGBT)).

Finally, it is clear that modifications and variations may be made to what has been described and illustrated herein, without thereby departing from the scope of this disclosure, as defined in the annexed claims. For example, the device may be any electronic device which has one or more aluminum pads, such as but not limited to silicon and/or silicon carbide (SiC) power devices. Non-limiting examples of power devices are metal-oxide-semiconductor field-effect transistors (MOSFETs), insulated-gate bipolar transistors (IGBT), and Schottky barrier diodes.

Examples of the present disclosure are the following:
Example 1. An electronic device comprising:
   a semiconductor substrate;
   an aluminum pad on the semiconductor substrate; and
   a stack comprising, in sequence:
      a barrier layer directly deposited on the aluminum pad;
      a seed layer directly deposited on the barrier layer, the seed layer comprising copper and having a thickness less than 800 nanometers (nm); and
      a metal layer directly deposited on the seed layer, the metal layer comprising nickel and palladium.
Example 2. The electronic device of example 1, wherein the metal layer comprises a first metal sub-layer comprising nickel directly deposited on the seed layer and a second metal sub-layer comprising palladium directly deposited on the first metal sub-layer.
Example 3. The electronic device of example 2, wherein the first metal sub-layer entirely covers a top surface of the seed layer.
Example 4. The electronic device of example 2, wherein the metal layer consists of the first and second metal sub-layers.
Example 5. The electronic device of example 1, wherein the seed layer has a thickness of 250-600 nm.
Example 6. The electronic device of example 1, wherein the metal layer has a thickness greater than 500 nm.
Example 7. The electronic device of example 1, wherein a sectional view of the seed layer has a substantially constant width from the barrier layer to the metal layer.
Example 8. The electronic device of example 1, wherein the seed layer consists of a single layer of copper.
Example 9. The electronic device of example 1, wherein the barrier layer comprises titanium, titanium-nitride, titanium-tungsten, tantalum, and/or tantalum-nitride.
Example 10. The electronic device of example 1, wherein the barrier layer consists of a layer made of titanium, titanium-nitride, titanium-tungsten, tantalum, and/or tantalum-nitride.
Example 11. A method of manufacturing an electronic device, the method comprising:
   providing an aluminum pad on a semiconductor substrate of the electronic device; and
   forming a stack on the aluminum pad, the forming comprising:
      depositing a barrier layer directly on the aluminum pad;
      depositing a seed layer directly on the barrier layer, the seed layer comprising copper and having a thickness less than 800 nanometers (nm); and
      depositing a metal layer directly on the seed layer, the metal layer comprising nickel and palladium.
Example 12. The method of example 11, wherein depositing the metal layer is performed via electroless deposition.
Example 13. The method of example 11, wherein depositing the barrier layer and the seed layer are performed via physical vapor deposition.
Example 14. The method of example 11, wherein depositing the metal layer directly on the seed layer comprises depositing a first metal sub-layer comprising nickel directly on the seed layer and depositing a second metal sub-layer comprising palladium directly on the first metal sub-layer.
Example 15. The method of example 14, wherein the first metal sub-layer substantially entirely covers a top surface of the seed layer.
Example 16. The method of example 11, wherein the seed layer is deposited with a thickness of 250-600 nm.
Example 17. The method of example 11, wherein the metal layer is deposited with a thickness greater than 500 nm.
Example 18. The method of example 11, wherein a sectional view of the seed layer has a substantially constant width from the barrier layer to the metal layer.
Example 19. The method of example 11, wherein the seed layer is deposited as a single layer of copper.
Example 20. The method of example 11, wherein the barrier layer is deposited as a single layer of titanium, titanium-nitride, titanium-tungsten, tantalum, and/or tantalum-nitride.

## Claims

1. An electronic device comprising:
a semiconductor substrate (170; 270);
an aluminum pad (110; 210) on the semiconductor substrate (170; 270); and
a stack (100; 200) comprising, in sequence:
a barrier layer (120; 220) directly deposited on the aluminum pad (110; 210);
a seed layer (130; 230) directly deposited on the barrier layer (120; 220), the seed layer (130; 230) comprising copper and having a thickness less than 800 nanometers ; and
a metal layer (140; 240) directly deposited on the seed layer (130; 230), the metal layer (140; 240) comprising nickel and palladium.

2. The electronic device of claim 1, wherein the metal layer (140; 240) comprises a first metal sub-layer (150; 250) comprising nickel directly deposited on the seed layer (130; 230) and a second metal sub-layer (160; 260) comprising palladium directly deposited on the first metal sub-layer (150; 250).

3. The electronic device of claim 2, wherein the first metal sub-layer (150; 250) entirely covers a top surface of the seed layer (130; 230).

4. The electronic device of claim 2, wherein the metal layer (140; 240) consists of the first (150; 250) and second (160; 260) metal sub-layers.

5. The electronic device of any of the preceding claims, wherein the seed layer (130; 230) has a thickness of 250-600 nm.

6. The electronic device of any of the preceding claims, wherein the metal layer (140; 240) has a thickness greater than 500 nm.

7. The electronic device of any of the preceding claims, wherein a sectional view of the seed layer (130; 230) has a substantially constant width from the barrier layer (120; 220) to the metal layer (140; 240).

8. The electronic device of any of the preceding claims, wherein the seed layer (130; 230) consists of a single layer of copper.

9. The electronic device of any of the preceding claim, wherein the barrier layer (120; 220) comprises titanium, titanium-nitride, titanium-tungsten, tantalum, and/or tantalum-nitride.

10. The electronic device of claim 1, wherein the barrier layer (120; 220) consists of a layer made of titanium, titanium-nitride, titanium-tungsten, tantalum, and/or tantalum-nitride.

11. A method of manufacturing an electronic device, the method comprising:
providing an aluminum pad (110; 210) on a semiconductor substrate (170; 270 of the electronic device; and
forming a stack (100; 200) on the aluminum pad, the forming comprising:
depositing a barrier layer (120; 220) directly on the aluminum pad (110; 210);
depositing a seed layer (130; 230) directly on the barrier layer (120; 220) , the seed layer comprising copper and having a thickness less than 800 nanometers; and
depositing a metal layer (140; 240) directly on the seed layer (130; 230), the metal layer comprising nickel and palladium.

12. The method of claim 11, wherein depositing the metal layer (140; 240) is performed via electroless deposition.

13. The method of claim 11 or 12, wherein depositing the barrier layer (120; 220) and the seed layer (130; 230) are performed via physical vapor deposition.

14. The method of any of claims 11-13, wherein depositing the metal layer (140; 240) comprises depositing a first metal sub-layer (150; 250) comprising nickel directly on the seed layer (130; 230) and depositing a second metal sub-layer (160; 260) comprising palladium directly on the first metal sub-layer, wherein the first metal sub-layer substantially entirely covers a top surface of the seed layer.

15. The method of claim 11, wherein the seed layer (130; 230) is deposited as a single layer of copper.
